# EUROPÄISCHE PATENTSCHRIFT

(11) **EP 2 178 010 B1**
(45) Veröffentlichungstag und Bekanntmachung des Hinweises auf die Patenterteilung: **06.04.2011**
(21) Anmeldenummer: 08018020.1
(22) Anmeldetag: 15.10.2008
(51) Int. Cl.: G06F 17/50, B05B 15/00

(54) **Methode zur Nachbildung eines Sprühvorgangs**
Method for modeling spray painting
Procédé de modelisation d'un processus de vernissage

(43) Veröffentlichungstag der Anmeldung: 21.04.2010
(73) Patentinhaber: ABB AG, 68309 Mannheim (DE)
(72) Erfinder: Börner, Gunter Dr. Ing., 74889 Sinsheim/Eschelbach (DE); Eickmeyer, Dietmar, Dr. Ing., 68542 Heddesheim (DE); Heye, Marc, 35037 Marburg (DE)
(74) Vertreter: Miller, Toivo

(56) Entgegenhaltungen:
- US-A1- 2003 097 242
- US-A1- 2004 245 354
- US-B1- 6 745 158
- ATKAR P N ET AL: "Paint Deposition Modeling for Trajectory Planning on Automotive Surfaces" IEEE TRANSACTIONS ON AUTOMATION SCIENCE AND ENGINEERING, IEEE SERVICE CENTER, NEW YORK, NY, US, Bd. 2, Nr. 4, 1. Oktober 2005 (2005-10-01), Seiten 381-392, XP011140038 ISSN: 1545-5955
- M.A.S. ARIKAN AND T. BALKAN: "Process Modeling, Simulation, and Paint Thickness Measurement for Robotic Spray Painting" JOURNAL OF ROBOTIC SYSTEMS, Bd. 17, Nr. 9, 2000, Seiten 479-494, XP002519170

## Beschreibung

Die Erfindung betrifft eine Methode zur Nachbildung eines Sprühvorganges einer Zerstäubervorrichtung. Es ist allgemein bekannt, dass ein Sprühvorgang einer Zerstäubervorrichtung für Lack, beispielsweise eines Hochrotationszerstäubers für industrielle Lackierung, von sehr vielen physikalischen Effekten beeinflusst ist, so dass sich eine mathematische Beschreibung eines Sprühvorganges zu Simulationszwecken als sehr komplex erweist.

Es sind Methoden bekannt, mit welchen der gesamten Sprüh- und Beschichtungsvorgang, also das Zerstäuben des Lackmaterials in eine Vielzahl kleiner Lackpartikel, die Ermittlung der Flugbahnen der jeweiligen Lackpartikel von dem Zerstäubungsort weg in Richtung einer zu beschichtenden Oberfläche und deren Ablagerungsvorgang auf der Oberfläche, bis zu einem gewissen Grad berechenbar ist. Aufgrund des extrem hohen Rechenaufwandes für eine statistisch relevante Vielzahl an Lackpartikel erweisen sich derartige Methoden als nachteilig, beispielsweise weil die von einem handelsüblichen Personalcomputer für die Berechnung eines einzigen Sprühvorgangs benötigte Rechenzeit mehrere Stunden beträgt. Bei der Beschichtung einer Oberfläche wie der Außenhaut einer Automobilkarosserie ist eine Vielzahl an Berechnungsvorgängen für jeweils einen Sprühvorgang erforderlich, so dass - je nach Genauigkeit des verwendeten physikalischen Modells - die hierfür benötigte Rechenzeit einige hundert Stunden beträgt.

Es sind auch weniger rechenintensive Methoden zur Nachbildung eines Sprühvorganges bekannt, welche unter Vereinfachung bestimmter physikalischer Randbedingungen und Hinnahme eines weniger genauen Berechnungsergebnisses eine sehr schnelle mathematische Berechnung eines Sprühvorgangs ermöglichen, beispielsweise innerhalb von Sekundenbruchteilen.

M.A.S. Arikan and T. Balkan zeigen in "Process Modeling, Simulation, and Paint Thickness Measurement for Robotic Spray Painting", Journal ofRobotic Systems, Bd. 17, Nr. 9, 2000, Seiten 479-494 ein Verfahren zur Nachbildung eines Sprühvorganges einer Zerstäubervorrichtung als virtuelle Quelle eines Sprühmediums zum Zwecke einer Schichtdickenbestimmung mit einer virtuellen Quelle des Sprühmediums, wobei den Abgabeorten jeweils ein individuell vorgebbarer, durch einen Dreh- und einen Kippwinkel definierter Raumwinkel und jeweils eine virtuelle Abgabemenge an austretendem Sprühmedium pro Zeiteinheit zugeordnet werden, wobei durch den Raumwinkel eine virtuelle Bewegungsrichtung des jeweils abgegebenen Sprühmediums bestimmt wird, wobei eine virtuelle zu behandelnde Oberfläche mit mehreren virtuellen Oberflächenelementen angeordnet wird, wobei das in Richtung des jeweiligen Abgabewinkels abgegebene Sprühmedium auf den Oberflächenelementen, auf welche es jeweils auftrifft, über einen Zeitraum zu einer jeweiligen Schichtdicke kumuliert wird, welche den jeweiligen Oberflächenelementen zugeordnet wird.

Eine weitere Methode ist beispielsweise aus der EP 1074 902 B1 bekannt. Hier wird mittels künstlicher neuronaler Netze ein Sprühbild berechnet, welches auf einer ebenen Abgabefläche mit einer Vielzahl von Abgabeflächenelementen dargestellt wird. Jedem Abgabeflächenelement ist ein den Sprühvorgang beschreibender Schichtdickenzuwachs pro Zeiteinheit zugeordnet. Ein Sprühbild stellt somit indirekt das Sprühergebnis eines zeitlich begrenzten Sprühvorganges einer unbewegten Zerstäubervorrichtung auf einer Fläche dar.

Bei der virtuellen Bewegung dieser Abgabefläche über eine virtuelle, parallele, zu beschichtende, ebene Oberfläche mit einer Vielzahl von Oberflächenelementen ergibt sich entsprechend der jeweiligen Verweildauer der Abgabeflächenelemente über den jeweiligen Oberflächenelementen durch Kumulation der Schichtdickenzuwächse eine jeweilige Schichtdicke auf der Oberfläche. Eine jeweilige virtuelle Flugbahn aller Lackpartikel von der Abgabefläche zur Oberfläche wird hierbei als senkrecht zu beiden Flächen angenommen.

Dieses Vorgehen ist auf eine ebene Darstellung eines Sprühbildes und eine Bewegung über eine ebene, parallele Oberfläche beschränkt. Um dennoch komplexe, dreidimensionale Oberflächengeometrien virtuell beschichten zu können, ist die Verwendung des Strahlensatzmodells zur Projektion des an sich ebenen Sprühbildes auf die Oberfläche bekannt, ähnlich einem Dia, welches auf eine komplexe Geometrie projiziert wird.

Hierbei wird angenommen, dass alle Flugbahnen der Lackpartikel von einem gemeinsamen Ursprung aus strahlenförmig, also längs einer jeweiligen Geraden, in Richtung der Oberfläche verlaufen.

Wie eingangs erwähnt ist eine jeweilige reale Flugbahn eines Lackpartikels sehr vielen Einflussfaktoren unterworfen und weicht je nach Zerstäubertyp erheblich von dem zuvor genannten Strahlensatzmodell ab. Bei einem Rotationszerstäuber beispielsweise erfolgt die Zerstäubung des Lacks mittels eines sich mit mehreren tausend Umdrehungen pro Minute drehenden Glockentellers mit einem Durchmesser von einigen Zentimetern. Der Lack wird axial mittig durch den Glockenteller an dessen Oberfläche geleitet und verläuft durch die wirkenden Zentrifugalkräfte ringsum an den Rand des Glockentellers, wo dann eine Zerstäubung des Lacks erfolgt. Nach der Zerstäubung bewegen sich jeweilige Lackpartikel zunächst auf einer jeweiligen annähernd radialen Flugbahn axial senkrecht vom Glockenteller weg. Durch längs der Drehachse des Glockentellers gerichtete und hinter dessen Aussenkante austretende Luftströme wird die Flugbahn im Weiteren in Richtung einer zu beschichtenden Oberfläche abgebogen. Eine weitere Beeinflussung der Flugbahn kann auch durch elektrostatische Effekte entstehen, wenn ein entsprechender Zerstäuber verwendet wird.

Diese erhebliche Abweichung der anhand des Strahlenmodells angenommenen Flugbahn eines Lackpartikels zu einer realen Flugbahn führt insbesondere bei der virtuellen Beschichtung von gekrümmten Oberflächen zu Berechnungsungenauigkeiten der auf der Oberfläche kumulierten Schichtdicken.

Ausgehend von diesem Stand der Technik ist es Aufgabe der Erfindung, eine verbesserte Methode zur Nachbildung eines Sprühvorganges einer Zerstäubervorrichtung als Quelle eines Sprühmediums anzugeben, welche die oben genannten Nachteile vermeidet.

Diese Aufgabe wird erfindungsgemäß gelöst durch die Merkmale des Anspruchs 1. Demgemäß ist vorgesehen, dass eine mehrere Abgabeflächenelemente umfassenden virtuellen Abgabefläche verwendet wird, welche der virtuellen Quelle des Sprühmediums abgewandt ist, wobei den Abgabeflächenelementen jeweils eine individuelle virtuelle Abgabemenge an Sprühmedium pro Zeiteinheit zugeordnet wird und wobei den Abgabeflächenelementen darüber hinaus auch jeweils ein individuell vorgebbarer Raumwinkel für die Abgaberichtung zugeordnet wird, durch welchen eine virtuelle Bewegungsrichtung des jeweils abgegebenen Sprühmediums relativ zur Ausrichtung der Abgabefläche bestimmt wird.

Eine Abgabefläche umfasst vorzugsweise eine Vielzahl an Abgabeflächenelementen, um so ein Sprühbild, also das Sprühergebnis eines zeitlich begrenzten Sprühvorganges einer unbewegten Zerstäubervorrichtung auf einer Fläche, darzustellen. Die Unterteilung der Abgabefläche in die jeweiligen Abgabeflächenelemente lässt sich bildlich mit einem Netz darstellen, welches die Abgabefläche überspannt. Jedem der so gebildeten Abgabeflächenelemente sind wenigstens folgende Werte zugeordnet:
- Die Raumkoordinaten des Abgabeflächenelementes, welche vorzugsweise dessen jeweiligen Flächenschwerpunkt beschreiben. Alternativ oder optional sind beispielsweise aber durchaus auch die Raumkoordinaten der Begrenzungslinien des Abgabeflächenelementes als zugeordnete Werte denkbar.
- Die Abgabemenge an Sprühmedium pro Zeiteinheit. Diese ist sowohl von dem eigentlich nachzubildenden Sprühvorgang abhängig, als auch von der flächigen Ausdehnung des Abgabeflächenelementes. Je höher die die Sprühintensität des nachzubildenden Sprühvorgangs im Bereich des Abgabeflächenelementes ist, desto höher ist auch der zugehörige Wert für die Abgabemenge an Sprühmedium pro Zeiteinheit. Je größer die flächige Ausdehnung des Abgabeflächenelementes, desto größer ist auch der vom Abgabeflächenelement nachgebildete Bereich und desto höher ist auch die Abgabemenge an Sprühmedium pro Zeiteinheit. Ein kleines Abgabeflächenelement, welches einen Bereich mit sehr hoher Sprühintensität nachbildet kann daher durchaus eine ähnliche Abgabemenge pro Zeiteinheit aufweisen, wie ein großes Abgabeflächenelement, welches einen Bereich mit geringer Sprühintensität nachbildet.
- Die Ausdehnung des Abgabeflächenelementes. Dies allerdings nur für den Fall, dass diese bei der jeweiligen Abgabemenge pro Zeiteinheit noch nicht berücksichtigt wurde.
- Der Raumwinkel, in dessen Richtung das Sprühmedium jeweils abzugeben ist. Der Raumwinkel bezieht sich letztendlich auf ein vorzugebendes feststehendes Bezugskoordinatensystem im Raum. Vorzugsweise wird die Ausrichtung der gesamten Abgabefläche mit einem Raumwinkel bezüglich des Bezugskoordinatensystems vorgegeben und die jeweiligen Raumwinkel der Abgabeflächenelemente beziehen sich auf die Ausrichtung der Abgabefläche.

Die Abgabefläche bildet quasi ein Sprühbild nach, welches sich auf einer Fläche in einem bestimmten Sprühabstand zum Zerstäuber ergibt. Durch die Verwendung einer Abgabefläche wird die Detailtiefe bei der Nachbildung des Sprühvorgangs bekanntermaßen zu Gunsten einer einfacheren Berechnung reduziert, nämlich auf eine Fläche im Raum, welche das Sprühverhalten in einem bestimmten Sprühabstand nachbildet, anstelle der Darstellung des Sprühvorganges im kompletten Raum für beliebig viele Sprühabstände.

Die daraus resultierenden bisher in Kauf genommene Ungenauigkeiten werden nun durch die erfindungsgemäße individuelle Zuordnung von Raumwinkeln für die Abgaberichtung der Abgabeflächenelemente in vorteilhafter Weise verringert, weil die jeweiligen Abgaberichtungen nunmehr genau um den für eine eventuelle Beschichtung einer Oberfläche maßgeblichen Sprühabstand realitätsnah vorgebbar sind.

Vorzugsweise ist die virtuelle Abgabefläche eben. Auf diese Weise lässt sich eine derartige Fläche mathematisch besonders einfach darstellen, beispielsweise in einer zweidimensionalen Matrix. Eine geeignete örtliche Ausdehnung einer virtuellen Abgabefläche liegt im Bereich der örtlichen Ausdehnung eines typischen Sprühvorganges bzw. eines diesen repräsentierenden Sprühbildes eines Luft-, Airless oder Rotationszerstäubers für Lack und beträgt beispielsweise 0,5m x 0,5m bis 1,5m x 1,5m. Eine geeignete entsprechende Matrix umfasst beispielsweise 100 x 100 bis 400 x 400 Elemente oder auch bedeutend mehr. Jedem Matrixelement sind dann die das Abgabeflächenelement beschreibenden Werte zugeordnet.

In einer zweckmäßigen Ausgestaltung der erfindungsgemäßen Methode werden die Raumwinkel wenigstens derjenigen Abgabeflächenelemente als aus einer ersten, der Sprühmediumsquelle abgewandten Seite der Abgabefläche austretend vorgegeben, denen dann jeweils auch eine einen Mindestwert überschreitende Abgabemenge an Sprühmedium zugeordnet wird. Dies ist eine realitätsnahe Einschränkung der vorgebbaren Raumwinkel, weil ein realer Sprühvorgang von der Sprühvorrichtung aus gesehen üblicherweise ausschließlich vorwärts und nie rückwärts gerichtet ist. Die Abgabe von Sprühmedium erfolgt in dieser Ausgestaltung der erfindungsgemäßen Methode demgemäß ausschließlich aus der ersten Seite der Abgabefläche.

In einer besonders bevorzugten Ausgestaltung der erfindungsgemäßen Methode wird der ersten Seite der Abgabefläche gegenüberliegend wenigstens eine virtuelle Oberfläche mit mehreren virtuellen Oberflächenelementen angeordnet. Das von den jeweiligen Abgabeflächenelementen in Richtung des jeweiligen Raumwinkels abgegebene Sprühmedium wird auf den Oberflächenelementen, auf welches es jeweils auftrifft, über einen Zeitraum zu einer jeweiligen Schichtdicke kumuliert, wobei die Schichtdicke den jeweiligen Oberflächenelementen zugeordnet wird.

Eine virtuelle Oberfläche wird ähnlich wie eine virtuelle Abgabefläche nachgebildet und stellt die Oberfläche oder einen Oberflächenteil eines zu beschichtenden Werkstückes dar. Die virtuelle Oberfläche ist ebenfalls als von einem Gitternetz umspannt vorzustellen und in entsprechende Oberflächenelemente unterteilt. Jedes Oberflächenelement ist durch seine Ausdehnung und einen zugeordneten Raumwinkel gekennzeichnet, wobei der Raumwinkel vorzugsweise entsprechend der Flächennormalen des jeweiligen Oberflächenelementes ausgerichtet ist. Die dem jeweiligen Oberflächenelement zugeordnete Schichtdicke ergibt sich aus der Kumulation des von den jeweiligen Abgabeflächenelementen abgegebenen Sprühmediums über einen bestimmten Zeitraum bezogen auf die Fläche des Oberflächenelementes, auf die es jeweils auftrifft. Auf diese Weise ist auch ein Beschichtungsvorgang einer Oberfläche in einfacher Weise nachbildbar.

In einer bevorzugten Variante der erfindungsgemäßen Methode wird bei der Kumulation des Sprühmediums zur Schichtdicke die Winkeldifferenz zwischen dem Raumwinkel des jeweils von einem Abgabeflächenelement abgegebenen Sprühmediums und dem Raumwinkel des Oberflächenelementes, auf welches das Sprühmedium auftrifft, berücksichtigt. So wird beispielsweise ein Sprühmedium, welches senkrecht zur Normalen eines Oberflächenelementes auf dieses auftrifft, zu 100% bei der Kumulation der Schichtdicke berücksichtigt. In einem sehr flachen Winkel auf das Oberflächenelement auftreffendes Sprühmedium wird hingegen lediglich zu einem geringen Prozentsatz berücksichtigt. Eine geeignete Beschreibungsfunktion ist beispielsweise eine Sinusfunktion in Abhängigkeit des relativen Auftreffwinkels, welcher sich seinerseits aus der Winkeldifferenz des jeweiligen Abgabewinkels eines Abgabeflächenelementes und dem Raumwinkel des Oberflächenelementes ergibt, auf welches das jeweils abgegebene Sprühmedium trifft. Auf diese Weise wird ein Beschichtungsvorgang noch realitätsnäher nachgebildet und auch ein Abpralleffekt berücksichtigt.

Gemäß einer weiteren vorteilhaften Ausgestaltung der erfindungsgemäßen Methode wird eine Kumulation der Schichtdicken der jeweiligen Oberflächenelemente in wenigstens zwei verschiedenen Relativpositionen der Abgabefläche und der Oberfläche zueinander durchgeführt. Hierdurch wird eine Bewegung einer Sprühvorrichtung um die zu beschichtende Oberfläche längs eines Bewegungspfades der Abgabefläche beziehungsweise der von dieser nachgebildeten Zerstäubervorrichtung dargestellt. Zweckmäßigerweise wird längs des Bewegungspfades in Kumulationsabständen, welche höchstens der Ausdehnung eines durchschnittlichen Abgabeflächenelementes entsprechen sollten, eine jeweilige Kumulation durchgeführt, wobei sich der virtuelle Zeitraum der Kumulation aus der jeweiligen Relativbewegungsgeschwindigkeit und den zuvor genannten Kumulationsabständen ergibt. Somit ist ein realer Beschichtungsvorgang noch besser nachzubilden.

Entsprechend der erfindungsgemäßen Methode werden zwei oder mehrere Abgabeflächen entlang derselben Ausrichtung hintereinander angeordnet, so dass wenigstens ein zweiseitig von den jeweiligen Abgabeflächen begrenzter Abgaberaum entsteht. Die jeweiligen Schichtdicken von jeweils in den wenigstens einen Abgaberaum hineinragenden Oberflächenelementen werden basierend auf den Abgabevolumina der den jeweiligen Abgaberaum begrenzenden Abgabeflächen kumuliert und die weiteren Oberflächenelemente basierend auf den Abgabevolumina der diesen zugewandten außen- d.h. nächstliegenden Abgabefläche. Jede Abgabefläche ist wie zuvor beschrieben für einen bestimmten Sprühabstand zwischen Zerstäubervorrichtung und zu beschichtender Oberfläche bestimmt. Bei Abweichungen des nachzubildenden Sprühabstandes von diesem bestimmten Sprühabstand erfolgt die Abgabe des Sprühmediums von der Abgabefläche in Richtung des vorgegebenen Abgabewinkels, so dass auch in einem Bereich um die Abgabefläche herum eine gute Approximation der Flugbahnen gegeben ist. Die beschriebene Anordnung von mehreren Abgabeflächen hintereinander ermöglicht es, diesen Bereich vorteilhaft zu erweitern, indem mehrere Einzelbereiche mit jeweils angepassten Abgabewinkeln hintereinander angeordnet werden.

In einer besonders bevorzugten Ausgestaltung der erfindungsgemäßen Methode werden wenigstens die virtuelle Abgabefläche mit den jeweiligen Abgabeflächenelementen, die virtuelle Oberfläche und deren Oberflächenelemente als Daten in einer Datenverarbeitungsanlage mit Arbeitsspeicher, beispielsweise einem Personalcomputer, gespeichert. Die virtuelle Abgabe des Sprühmediums sowie die Kumulation der Schichtdicke werden vorteilhafter Weise ebenfalls unter Verwendung einer Datenverarbeitungsanlage durchgeführt. Eine schnelle Berechnung eines Sprühvorganges lässt sich auf diese Weise besonders einfach durchführen.

Einer weiteren bevorzugten Ausgestaltung der erfindungsgemäßen Methode zufolge wird die virtuelle Oberfläche aus einem CAD Modell wenigstens eines Werkstückes generiert. Dies erfolgt vorzugsweise mit einer geeigneten Datenverarbeitungsanlage. Es ist hierbei vorteilhaft, die Oberflächenelemente der generierten Oberfläche möglichst ähnlich groß zu gestalten und auch ähnlich groß wie die Abgabeflächenelemente. Hierdurch ist der virtuelle Beschichtungsvorgang möglichst geringen Fehlern unterworfen, welche sich aus der Quantelung der jeweiligen Flächen ergeben.

CAD Modelle bilden eine Oberfläche ebenfalls aus einer Vielzahl von Oberflächenelementen nach, welche üblicherweise umso kleiner ausfallen, je komplexer der Bereich der Oberfläche ist, der durch sie dargestellt wird. Da eine virtuelle Oberfläche für die Beschichtung wie zuvor erwähnt idealerweise jeweils ähnlich große Flächenelemente aufweist, kann ein vorhandenes CAD Modell jedoch erst nach einer entsprechenden Anpassung als Modell für eine zu beschichtende Oberfläche verwendet werden.

Anhand der in den Zeichnungen dargestellten Ausführungsbeispiele sollen die Erfindung, weitere Ausführungsformen und weitere Vorteile näher beschrieben werden.

Es zeigen:
- Fig. 1: ein exemplarisches Abgabeflächenelement,
- Fig. 2: eine exemplarische Abgabefläche,
- Fig. 3: ein Beispiel für einen strahlenförmig nachgebildeten Sprühvorgang,
- Fig. 4: ein Beispiel für erfindungsgemäß nachgebildeten Sprühvorgang und
- Fig. 5: eine exemplarische Anordnung von Abgabeflächen

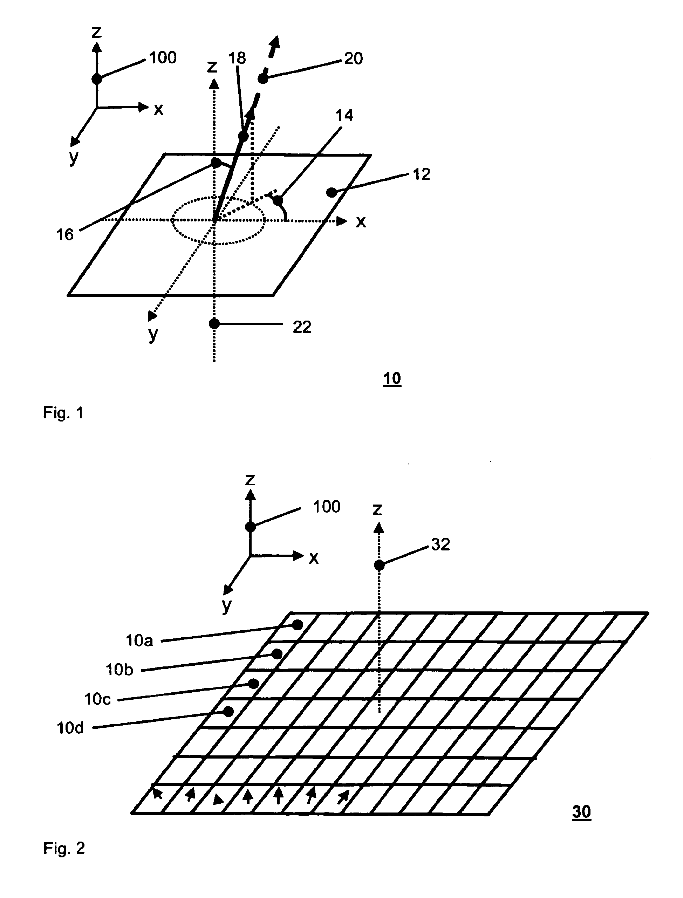

Fig. 1 zeigt ein exemplarisches Abgabeflächenelement 10 in dreidimensionaler Darstellung mit dem Bezugskoordinatensystem 100. In der Mitte des quadratischen Abgabeflächenelementes 12 sind ein erster Abgaberichtungsvektor 18 und ein zweiter Abgaberichtungsvektor 20 dargestellt. Der Raumwinkel der beiden Vektoren ist identisch und durch den Drehwinkel 14 und den Kippwinkel 16 vorgegeben. Die jeweilige Länge der Vektoren 18, 20 ist ein Maß für die jeweilige Abgabemenge an Sprühmedium pro Zeiteinheit. Die Ausrichtung des Abgabeflächenelementes entspricht seiner Flächennormalen 22, welche in der dargestellten Fig. dieselbe Ausrichtung wie die Z-Achse des Bezugssystems 100 aufweist. Vorzugsweise sind die genannten Werte für die Umsetzung der erfindungsgemäßen Methode in einem Speicher einer Datenverarbeitungsanlage gespeichert, um so ein einfaches Durchführen der erfindungsgemäßen Methode zu ermöglichen.

Fig. 2 zeigt eine exemplarische Abgabefläche 30, welche eine Vielzahl von dem exemplarischen Abgabeflächenelement 10 im Wesentlichen entsprechenden Abgabeflächenelementen 10a, 10b, 10c, 10d aufweist. Eine jeweils individuelle Abgaberichtung der jeweiligen Abgabeflächenelemente ist durch einige in verschiedenen Richtungen zeigende Vektoren angedeutet. Weiterhin gezeigt ist ein Bezugskoordinatensystem 100, dessen Z-Achse in dieser Fig. dieselbe Ausrichtung wie die Ausrichtung 32 der Abgabefläche 30 aufweist, wobei diese selbstverständlich auch voneinander abweichen können. Die ebene Ausgestaltung der Abgabefläche 30 mit den rechteckförmigen, gleichgroßen Abgabeflächenelementen 10a, 10b, 10c, 10d ist besonders geeignet, um in Form einer Matrix beziehungsweise eines Datenarrays in einer Datenverarbeitungsanlage gespeichert zu werden, um die Durchführen der erfindungsgemäßen Methode zu vereinfachen.

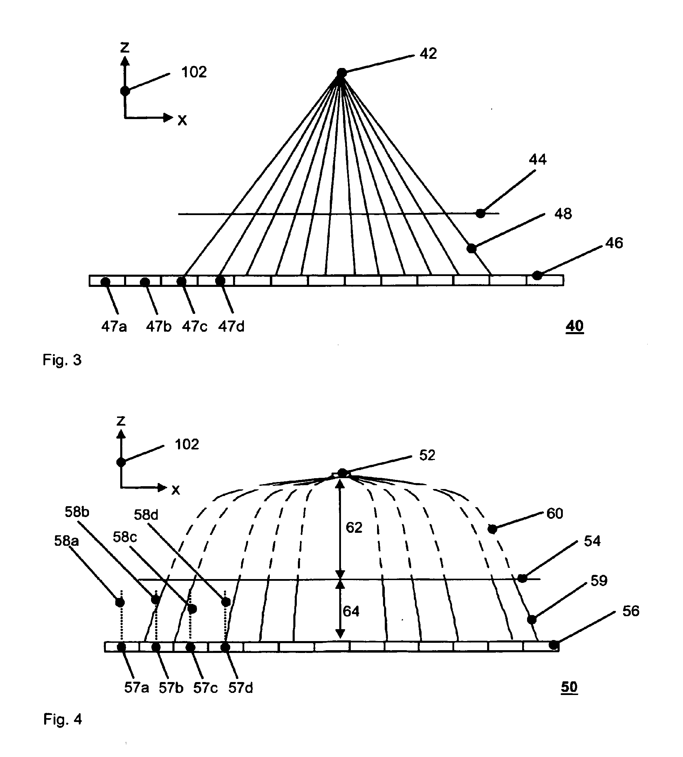

Fig. 3 zeigt ein Beispiel 40 für einen strahlenförmig nachgebildeten Sprühvorgang in zweidimensionaler Form mit dem zugehörigen Bezugssystem 102. Eine erste Abgabefläche 44 ist oberhalb einer ersten Oberfläche 46 angeordnet. Die erste Abgabefläche entspricht im Wesentlichen mit Ausnahme der Zuordnung eines jeweiligen Raumwinkels zu den jeweiligen Abgabeflächenelementen der Abgabefläche 30. Die erste Oberfläche weist eine Vielzahl an mit den Bezugszeichen 47a, 47b, 47c, 47d angedeuteten Oberflächenelementen auf, welche in einer dreidimensionalen Darstellung entsprechend Fig. 2 ebenfalls rechteckförmige Flächen wären. Ein jeweiliger Raumwinkel ergibt sich aus dem Strahlensatzmodell, bei dem ein strahlenförmiger Verlauf der virtuellen Flugbahnen, welche hier in einem Fall mit dem Bezugszeichen 48 angedeutet sind, von der virtuellen ersten punktförmigen Sprühmediumsquelle 42 angenommen wird.

Fig. 4 zeigt ein Beispiel 50 für einen erfindungsgemäß nachgebildeten Sprühvorgang mit dem zugehörigen Bezugssystem 102 in zweidimensionaler Darstellung. Eine zweite Abgabefläche 54 ist oberhalb einer zweiten Oberfläche 56 angeordnet. Die zweite Abgabefläche entspricht einschließlich der Zuordnung eines jeweiligen Raumwinkels zu den jeweiligen Abgabeflächenelementen im Wesentlichen der Abgabefläche 30. Die erste Oberfläche weist eine Vielzahl von mit den Bezugszeichen 57a, 57b, 57c, 57d angedeuteten Oberflächenelementen auf. Die Oberflächenelemente weisen zudem eine jeweilige durch einen Raumwinkel vorgegebene Ausrichtung 58a, 58b, 58c und 58d auf, welche im Beispiel zwar aus Einfachheitsgründen in gleicher Ausrichtung dargestellt sind, welche aber den Gegebenheiten der jeweils zu beschichtenden Oberfläche entsprechend als verschieden ausgerichtet angenommen werden sollten. Oberhalb der zweiten Abgabefläche 54 sind zu Verständniszwecken jeweilige Flugbahnen 60 für Lackpartikel angedeutet, welche von einer virtuellen zweiten Sprühmediumsquelle 52 ausgehen und in etwa einen realistischen Flugbahnverlauf darstellen, welcher in diesem Bereich erfindungsgemäß aber nicht berücksichtigt wird. Durch die Abgabefläche 54 wird der Strom der jeweiligen Sprühmediumspartikel in einem Referenzsprühabstand 62 dargestellt, beispielsweise 25cm. Bei einem nachzubildenden Sprühabstand von 30cm ergäbe sich ein zusätzlicher Sprühabstand 64, in diesem Fall 5cm, bei dem der jeweilige Raumwinkel des abgegebenen Sprühmediums entsprechend den von der zweiten Abgabefläche 54 ausgehenden linearen Flugbahnen berücksichtigt wird, wobei in der Fig. eine Flugbahn mit der Bezugsnummer 59 versehen ist. Deutlich zu sehen sind hier im Vergleich mit dem in Fig. 3 gezeigten strahlenförmigen Sprühvorgang die deutlich realistischere Flugbahnen.

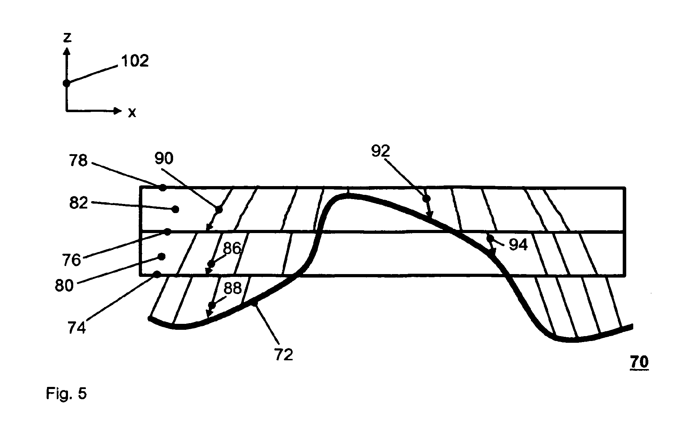

Fig. 5 zeigt eine Anordnung 70 von mehreren Abgabeflächen 74, 76, 78 hintereinander in zweidimensionaler Darstellung mit dem zugehörigen Bezugssystem 102. Zwischen der zweiten 74 und dritten 76 Abgabefläche ist ein erster Abgaberaum 80 gebildet und entsprechend zwischen der dritten 76 und der vierten Abgabefläche 78 ein Abgaberaum 82, dessen seitliche Begrenzung sich aus der Erstreckung der ihn oben und unten begrenzenden Abgabeflächen ergibt. Eine dritte Oberfläche mit in dieser Darstellung nicht gezeigten Oberflächenelementen ragt in den ersten 80 und zweiten 82 Abgaberaum hinein. Die in den zweiten Abgaberaum hineinragenden Oberflächenelemente der Oberfläche 72 werden virtuell von der vierten Abgabefläche 78 beschichtet, welche in diesem Beispiel einen Sprühabstand von 10cm nachbildet. Die Flugbahnen 90, 92 des Sprühmaterials sind in dem Abgaberaum 82 linear und entsprechen dem jeweiligen Abgabewinkel der jeweiligen in dieser Fig. nicht gezeigten Abgabeflächenelementen.

Entsprechendes gilt für in den ersten Abgaberaum 80 hineinragende Oberflächenelemente, welche von der dritten Abgabefläche 76 beschichtet werden, welche ihrerseits einen Sprühabstand von beispielsweise 20cm nachbildet. Analog werden alle Oberflächenelemente mit einem Sprühabstand größer als 30cm von der diesen Abstand nachbildenden zweiten Abgabefläche 74 beschichtet. Somit lässt insbesondere trotz einer sehr großen Variation des Sprühabstandes eine hohe Berechnungsgenauigkeit erzielen.

### Bezugszeichenliste

- 10: exemplarisches Abgabeflächenelement
- 10a: erstes Abgabeflächenelement
- 10b: zweites Abgabeflächenelement
- 10c: drittes Abgabeflächenelement
- 10d: viertes Abgabeflächenelement
- 12: Abgabeflächenelement
- 14: Drehwinkel
- 16: Kippwinkel
- 18: erster Abgaberichtungsvektor
- 20: zweiter Abgaberichtungsvektor
- 22: Ausrichtung des exemplarischen Abgabeflächenelementes
- 30: exemplarische Abgabefläche
- 32: Ausrichtung der exemplarischen Abgabefläche
- 40: Beispiel für strahlenförmig nachgebildeten Sprühvorgang
- 42: virtuelle erste Sprühmediumsquelle
- 44: erste Abgabefläche
- 46: erste Oberfläche
- 47a: erstes Oberflächenelement der ersten Oberfläche
- 47b: zweites Oberflächenelement der ersten Oberfläche
- 47c: drittes Oberflächenelement der ersten Oberfläche
- 47d: viertes Oberflächenelement der ersten Oberfläche
- 48: erste exemplarische virtuelle Flugbahn
- 50: Beispiel für erfindungsgemäß nachgebildeten Sprühvorgang
- 52: virtuelle zweite Sprühmediumsquelle
- 56: zweite Oberfläche mit Oberflächenelementen
- 54: zweite Abgabefläche
- 56: zweite Oberfläche
- 57a: erstes Oberflächenelement der zweiten Oberfläche
- 57b: zweites Oberflächenelement der zweiten Oberfläche
- 57c: drittes Oberflächenelement der zweiten Oberfläche
- 57d: viertes Oberflächenelement der zweiten Oberfläche
- 58a: Ausrichtung des ersten Oberflächenelements der zweiten Oberfläche
- 58b: Ausrichtung des zweiten Oberflächenelements der zweiten Oberfläche
- 58c: Ausrichtung des dritten Oberflächenelements der zweiten Oberfläche
- 58d: Ausrichtung des vierten Oberflächenelements der zweiten Oberfläche
- 59: zweite exemplarische virtuelle Flugbahn
- 60: dritte exemplarische virtuelle Flugbahn
- 62: Referenzsprühabstand
- 64: Zusätzlicher Sprühabstand
- 70: exemplarische Anordnung von Abgabeflächen in zweidimensionaler An- sicht
- 72: dritte Oberfläche
- 74: zweite Abgabefläche
- 76: dritte Abgabefläche
- 78: vierte Abgabefläche
- 80: erster Abgaberaum
- 82: zweiter Abgaberaum
- 86: vierte exemplarische virtuelle Flugbahn
- 88: fünfte exemplarische virtuelle Flugbahn
- 90: sechste exemplarische virtuelle Flugbahn
- 92: siebte exemplarische virtuelle Flugbahn
- 94: achte exemplarische virtuelle Flugbahn
- 100: dreidimensionales Bezugssystem in dreidimensionaler Darstellung
- 102: dreidimensionales Bezugssystem in zweidimensionaler Schnittdarstellung

## Patentansprüche

1. Computerimplementürhe Methode zur Nachbildung eines Sprühvorganges einer Zerstäubervorrichtung als virtuelle Quelle (42) eines Sprühmediums *zum Zwecke einer Schichtdickenbestimmung,* mit *wenigstens zwei hintereinander angeordneten* jeweils mehrere Abgabeflächenelemente (10, 10a, 10b, 10c, 10d, 12) umfassenden virtuellen Abgabeflächen (30, 54, 74, 76, 78) *mit einer gleichen, der virtuellen Quelle des Sprühmediums mit ihrer ersten Seite abgewandten, Ausrichtung (32),* wobei den Abgabeflächenelementen (10, 10a, 10b. 10c, 10d, 12) jeweils ein individuell vorgebbarer, durch einen Dreh- und einen Kippwinkel definierter Raumwinkel (14, 16) und jeweils eine individuelle virtuelle Abgabemenge an *aus der ersten Seite austretendem* Sprühmedium pro Zeiteinheit zugeordnet werden, wobei durch den Raumwinkel eine virtuelle Bewegungsrichtung (48, 59, 86, 88, 90, 92, 94) des jeweils abgegebenen Sprühmediums relativ zur Ausrichtung der Abgabeflächen (32) bestimmt wird, wobei der ersten Seite jeder Abgagbefläche (30, 54, 74, 76, 78) gegenüberliegend wenigstens eine virtuelle Oberfläche (46, 56, 72) mit mehreren virtuellen Oberflächenelementen (47a-d, 57a-d) angeordnet wird wobei das von den jeweiligen Abgabeflächenelementen (10 10a 10b 10c 10d 12) in Richtung des jeweiligen Abgabewinkels (14, 16) abgegebene Sprühmedium auf den Oberflächenelementen (47a-d, 57a-d), auf welche es jeweils auftrifft über einen Zeitraum zu einer jeweiligen Schichtdicke kumuliert wird, welche den jeweiligen Oberflächenelementen (47a-d, 57a-d) zugeordnet wird, *wobei wenigstens ein zweiseitig von den wenigstens zwei Abgabeflächen (30, 54*, *74*, *76*, *78) begrenzter Abgaberaum (80, 82) gebildet ist, wobei die jeweiligen Schichtdicken von jeweils in den wenigstens einen Abgaberaum (80, 82) hineinragenden Oberflächenelementen (47a-d, 57a-d) basierend auf den Abgabevolumina der den jeweiligen Abgaberaum (80,* 82*) begrenzenden Abgabeflächen (76,* 78) *kumuliert werden und wobei die weiteren Oberflächenelemente (47a-d, 57a-d) basierend auf den Abgabevolumina der diesen zugewandten außen liegenden Abgabefläche (74) kumuliert werden.*

2. Methode nach Anspruch 1, **dadurch gekennzeichnet, dass** die virtuellen Abgabeflächen (30, 54, 74, 76, 78) eben sind.

3. Methode nach Anspruch 1 oder 2, **dadurch gekennzeichnet, dass** der Sprühvorgang eines Luft-, Airless- oder Rotationszerstäubers für Lack nachgebildet wird.

4. Methode nach einem der vorangegangen Ansprüche, **dadurch gekennzeichnet, dass** beim Kumulieren des Sprühmediums zur Schichtdicke die Winkeldifferenz zwischen dem Abgabevektor (14, 16) des jeweils von einem Abgabeflächenelement (10, 10a, 10b, 10c, 10d, 12) abgegebenen Sprühmediums und dem Raumwinkel (58a-d) des Oberflächenelementes (47a-d, 57a-d), auf welches das Sprühmedium auftrifFt, berücksichtigt wird.

5. Methode nach einem der vorangegangen Ansprüche, **dadurch gekennzeichnet, dass** eine Kumulation der Schichtdicken der jeweiligen Oberflächenelemente (47a-d, 57a-d) in wenigstens zwei verschiedenen Relativpositionen der Abgabefläche (30, 54, 74, 76, 78) und der Oberfläche (46, 56, 72) zueinander durchgeführt wird.

6. Methode nach einem der vorangegangen Ansprüche, **dadurch gekennzeichnet, dass** wenigstens die virtuellen Abgabeflächen (30, 54, 74, 76, 78) mit den jeweiligen Abgabeflächenelementen (10, 10a, 10b, 10c, 10d, 12), die virtuelle Oberfläche (46, 56, 72) und deren Oberflächenelemente (47a-d, 57a-d) als Daten in einer Datenverarbeitungsanlage gespeichert werden.

7. Methode nach Anspruch 6, **dadurch gekennzeichnet, dass** wenigstens die virtuelle Abgabe des Sprühmediums sowie die Kumulation der Schichtdicke unter Verwendung einer Datenverarbeitungsanlage durchgeführt werden.

8. Methode nach Anspruch 6 oder 7, **dadurch gekennzeichnet, dass** die virtuelle Oberfläche (46, 56, 72) aus einem CAD Modell wenigstens eines Werkstückes generiert wird.

## Claims

1. Computer-implemented method for simulating a spraying operation of an atomizer device as a virtual source (42) of a spray medium for the purpose of layer-thickness determination, with at least two successively arranged virtual discharge surfaces (30, 54, 74, 76, 78) comprising in each specific case a plurality of discharge-surface elements (10, 10a, 10b, 10c, 10d, 12) and having an identical orientation (32) facing with its first side away from the virtual source of the spray medium, the discharge-surface elements (10, 10a, 10b, 10c, 10d, 12) being assigned in each case an individually stipulatable solid angle (14, 16), defined by an angle of rotation and a tilting angle, and in each case an individual virtual discharge quantity of spray medium, emerging from the first side, per unit time, a virtual direction of movement (48, 59, 86, 88, 90, 92, 94) of the in each case discharged spray medium in relation to the orientation of the discharge surface (32) being determined by means of the solid angle, at least one virtual surface (46, 56, 72) with a plurality of virtual surface elements (47a-d, 57a-d) being arranged opposite the first side of each discharge surface (30, 54, 74, 76, 78), the spray medium which is discharged by the respective discharge-surface elements (10, 10a, 10b, 10c, 10d, 12) in the direction of the respective discharge angle (14, 16) being accumulated on the surface elements (47a-d, 57a-d), onto which it impinges in each case, over a period of time so as to form a respective layer thickness which is assigned to the respective surface elements (47a-d, 57a-d), at least one discharge space (80, 82) delimited on two sides by the at least two discharge surfaces (30, 54, 74, 76, 78) being formed, the respective layer thicknesses of surface elements (47a-d, 57a-d), projecting in each case into the at least one discharge space (80, 82), being accumulated on the basis of the discharge volumes of the discharge surfaces (76, 78) delimiting the respective discharge space (80, 82), and the further surface elements (47a-d, 57-d) being accumulated based on the discharge volumes of the external discharge surface (74) facing these.

2. Method according to Claim 1, **characterized in that** the virtual discharge surfaces (30, 54, 74, 76, 78) are planar.

3. Method according to Claim 1 or 2, **characterized in that** the spraying operation of an air, airless or rotary atomizer is simulated for paint.

4. Method according to one of the preceding claims, **characterized in that**, in the accumulation of the spray medium to form the layer thickness, the angular difference between the discharge vector (14, 16) of the spray medium discharged in each case by a discharge-surface element (10, 10a, 10b, 10c, 10d, 12) and the solid angle (58a-d) of the surface element (47a-d, 57a-d) onto which the spray medium impinges is taken into account.

5. Method according to one of the preceding claims, **characterized in that** an accumulation of the layer thicknesses of the respective surface elements (47a-d, 57a-d) is carried out in at least two different relative positions of the discharge surface (30, 54, 74, 76, 78) and of the surface (46, 56, 72) with respect to one another.

6. Method according to one of the preceding claims, **characterized in that** at least the virtual discharge surfaces (30, 54, 74, 76, 78) with the respective discharge-surface elements (10, 10a, 10b, 10c, 10d, 12), the virtual surface (46, 56, 72) and its surface elements (47a-d, 57a-d) are stored as data in a data processing installation.

7. Method according to Claim 6, **characterized in that** at least the virtual discharge of the spray medium and the accumulation of the layer thickness are carried out using a data processing installation.

8. Method according to Claim 6 or 7, **characterized in that** the virtual surface (46, 56, 72) is generated from a CAD model of at least one workpiece.

## Revendications

1. Procédé assisté par ordinateur pour la modélisation d'une opération de pulvérisation d'un dispositif de pulvérisateur comme source virtuelle (42) d'un fluide à pulvériser dans le but de déterminer une épaisseur de couche avec au moins deux faces de délivrance virtuelles (30, 54, 74, 76, 78) disposées l'une derrière l'autre comprenant chacune plusieurs éléments de face de délivrance (10, 10a, 10b, 10c, 10d, 12) avec une même orientation (32) située avec son premier côté à l'opposé de la source virtuelle du fluide à pulvériser, dans lequel on associe aux éléments de face de délivrance (10, 10a, 10b, 10c, 10d, 12) chaque fois un angle spatial (14, 16) pouvant être prédéfini individuellement, défini par un angle de rotation et un angle d'inclinaison, et chaque fois une quantité de délivrance virtuelle individuelle du fluide à pulvériser sortant du premier côté par unité de temps, dans lequel on détermine au moyen de l'angle spatial une direction de mouvement virtuelle (48, 59, 86, 88, 90, 92, 94) du fluide à pulvériser respectivement délivré par rapport à l'orientation de la face de délivrance (32), dans lequel on dispose au moins une surface virtuelle (46, 56, 72) avec plusieurs éléments de surface virtuels (47a-d, 57a-d) en face du premier côté de chaque face de délivrance (30, 54, 74, 76, 78), dans lequel on cumule le fluide à pulvériser, délivré par les éléments de face de délivrance respectifs (10, 10a, 10b, 10c, 10d, 12) en direction de l'angle de délivrance respectif (14, 16), pendant un laps de temps sur les éléments de surface respectifs (47a-d, 57a-d) sur lesquels il arrive respectivement, en une épaisseur de couche respective qui est associée aux éléments de surface respectifs (47a-d, 57a-d), dans lequel on forme au moins un espace de délivrance (80, 82) délimité sur deux côtés par les au moins deux faces de délivrance (30, 54, 74, 76, 78), dans lequel on cumule les épaisseurs de couche respectives d'éléments de surface respectifs (47a-d, 57a-d) pénétrant dans ledit au moins un espace de délivrance (80, 82) en se basant sur les volumes de délivrance des faces de délivrance (76, 78) délimitant l'espace de délivrance respectif (80, 82), et dans lequel on cumule les autres éléments de surface (47a-d, 57a-d) en se basant sur les volumes de délivrance de la face de délivrance située à l'extérieur (74) tournée vers ceux-ci.

2. Procédé selon la revendication 1, **caractérisé en ce que** les faces de délivrance virtuelles (30, 54, 74, 76, 78) sont planes.

3. Procédé selon la revendication 1 ou 2, **caractérisé en ce que** l'on modélise l'opération de pulvérisation d'un pulvérisateur à l'air, sans air ou rotatif pour un vernis.

4. Procédé selon l'une quelconque des revendications précédentes, **caractérisé en ce que**, lors du cumul du fluide à pulvériser en une épaisseur de couche, on tient compte de la différence d'angle entre le vecteur de délivrance (14, 16) du fluide à pulvériser délivré respectivement par un élément de face de délivrance (10, 10a, 10b, 10c, 10d, 12) et l'angle spatial (58a-d) de l'élément de surface (47a-d, 57a-d) sur lequel le fluide à pulvériser arrive.

5. Procédé selon l'une quelconque des revendications précédentes, **caractérisé en ce que** l'on effectue un cumul des épaisseurs de couche des éléments de surface respectifs (47a-d, 57a-d) dans au moins deux positions relatives différentes de la face de délivrance (30, 54, 74, 76, 78) et de la surface (46, 56, 72) l'une par rapport à l'autre.

6. Procédé selon l'une quelconque des revendications précédentes, **caractérisé en ce que** l'on mémorise au moins les faces de délivrance virtuelles (30, 54, 74, 76, 78) avec les éléments de face de délivrance respectifs (10, 10a, 10b, 10c, 10d, 12), la surface virtuelle (46, 56, 72) et ses éléments de surface (47ad, 57a-d) sous forme de données dans une installation de traitement de données.

7. Procédé selon la revendication 6, **caractérisé en ce que** l'on effectue la délivrance virtuelle du fluide à pulvériser ainsi que le cumul de l'épaisseur de couche en utilisant une installation de traitement de données.

8. Procédé selon la revendication 6 ou 7, **caractérisé en ce que** l'on génère la surface virtuelle (46, 56, 72) à partir d'un modèle CAO d'au moins une pièce.
